# EUROPEAN PATENT APPLICATION

(11) **EP 1 014 561 A2**
(43) Date of publication of application: **28.06.2000**
(21) Application number: 99310063.5
(22) Date of filing: 14.12.1999
(51) Int. Cl.: H03D 7/16, H03L 7/22

(54) **Intermediate frequency generating circuit**

(30) Priority: 18.12.1998 JP 36162398
(71) Applicant: Mitsumi Electric Company Ltd., Chofu-shi Tokyo (JP)
(72) Inventor: Ogino, Toshikazu, Mitsumi Electric Co., Ltd., Atsugi-shi, Kanagawa (JP); Yamasaki, Masashige, Mitsumi Electric Co., Ltd., Atsugi-shi, Kanagawa (JP); Shibano, Hayato, Mitsumi Electric Co., Ltd., Atsugi-shi, Kanagawa (JP)
(74) Representative: Midgley, Jonathan Lee

(57) **Abstract**

An intermediate frequency generating circuit has two frequency mixing circuits and two local oscillating circuits for applying local oscillation outputs to the two frequency mixing circuits. In the intermediate frequency generating circuit, the two local oscillating circuits are used as voltage controlled oscillators for two PLL circuits, respectively. In addition, the two PLL circuits excluding the two voltage controlled oscillators are provided in a single integrated circuit.

## Description

### BACKGROUND OF THE INVENTION

### 1. Field of the Invention

The present invention generally relates to intermediate frequency generating circuits, and more particularly to an intermediate frequency generating circuit in which VCOs (Voltage Controlled Oscillators) of two PLL (Phase Locked Loop) circuits are used as local oscillators of two frequency mixers.

### 2. Description of the Related Art

In a conventional receiver, in order to improve selectivity to a received signal, the received signal is converted into an intermediate frequency and is demodulated so that a desired signal is obtained. Also, in a telephone receiver module utilizing open channels of a CATV (Cable Television) line, an intermediate frequency circuit, which converts the received signal to an intermediate frequency by two stages of frequency mixers, is utilized.

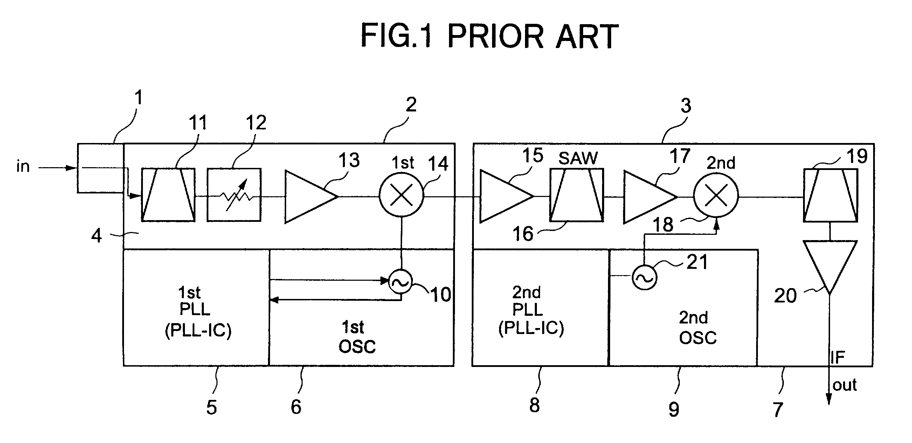

FIG.1 shows an example of the intermediate frequency circuit in the telephone receiver module utilizing the CATV line. The intermediate frequency circuit in FIG.1 includes a first intermediate frequency generating circuit 2 and a second intermediate frequency generating circuit 3. The received signal is applied to the first intermediate frequency generating circuit 2 and an intermediate frequency IF of the received signal is output.

The first intermediate frequency generating circuit 2 includes blocks, which are sectioned by partitions such as metal partitions, namely, a first frequency mixing circuit block 4, a first oscillator circuit block 5 and a first PLL circuit block 6. The second intermediate frequency generating circuit 3 also includes blocks, namely, a second frequency mixing circuit block 7, a second PLL circuit block 8 and a second oscillator circuit block 9.

The first frequency mixing circuit block 4 includes a BPF (Band Pass Filter) 11, an AGC (Automatic Gain Control) 12, an amplifier 13 and a first frequency mixer 14.

In the first oscillator circuit block 5, a first oscillator 10 is provided and functions as a VCO for a PLL (not shown) provided in the first PLL circuit block 6.

Noise that is received with the received signal applied to an input port 1 is eliminated by the BPF 11. An amplitude level of the received signal is adjusted by the AGC 12. Subsequently, the received signal is amplified by the amplifier 13 and is mixed with an output frequency of the first oscillator 10 by the first frequency mixer 14. Then, a frequency of the received signal is converted and output from the first frequency mixer 14.

The second frequency mixing circuit block 7 includes an amplifier 15, a SAW (Surface Acoustic Wave) 16, an amplifier 17, a second frequency mixer 18, a BPF 19 and an amplifier 20.

In the second oscillator circuit block 8, a second oscillator 21 is provided and functions as a VCO for a PLL (not shown) provided in the second PLL circuit block 9.

An output of the first frequency mixer 14 is amplified by the amplifier 15 and noise is eliminated by the SAW 16. Moreover, the output is amplified by the amplifier 17 and is mixed with an output of the second oscillator 21 by the second frequency mixer 18. As a result, the frequency of the received signal is converted. A converted received signal is filtered by the BPF 19 and amplified by the amplifier 20, and then an intermediate frequency is output.

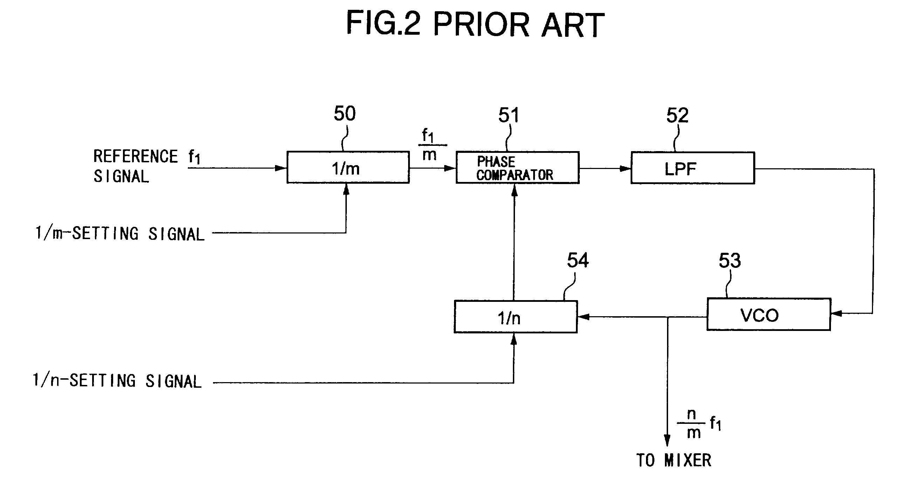

FIG.2 is a diagram showing a conventional PLL circuit. An output of a VCO 53 is divided by n by a frequency divider 54 and a 1/n the VCO output frequency is applied to a phase comparator 51. On the contrary, a reference frequency fl of a reference signal is divided by m by a frequency divider 50 and a 1/m the reference frequency fl is applied to the phase comparator 51. The phase comparator 51 compares a phase of 1/m the reference frequency fl from the frequency divider 50 with a phase of 1/n the VCO output frequency from the frequency divider 54. The phase comparator 51 applies a signal which is proportional to a phase error to a LPF (Low Pass Filter) 52. An output of the LPF 52 controls the output signal frequency of the VCO 53. As a result, n/m the reference frequency fl is obtained from the VCO 53.

In the example of the conventional intermediate frequency generating circuit shown in FIG.1, the PLL circuit blocks 6 and 8 are used. Also, a circuit board of the first intermediate frequency generating circuit 2 is separated from that of the second intermediate frequency circuit 3. In addition, the patterning in circuit design and arrangement of parts are made so as not to leak a spurious signal caused on the first intermediate frequency generating circuit 2 to the second intermediate frequency generating circuit 3. For example, a supply voltage and a ground for the first intermediate frequency generating circuit 2 are completely separated from a supply voltage and a ground for the first intermediate frequency generating circuit 3.

However, in the second PLL circuit block 8 in the second intermediate frequency generating circuit 3, the reference frequency fl as shown in FIG.2 and two digital setting signals for frequency division ratios, which are 1/m-setting signal and 1/n-setting signal as shown in FIG.2, leak to the second frequency mixer circuit block 7 and mix with an intermediate frequency (IF).

### SUMMARY OF THE INVENTION

It is a general object of the present invention to provide an intermediate frequency generating circuit having PLL circuits in which the above-mentioned problems are eliminated.

A more specific object of the present invention is to provide an intermediate frequency generating circuit in which the circuit construction is simplified and reference frequency signals of PLL circuits and setting signals for frequency division ratios of frequency dividers are prevented from leaking and mixing into intermediate frequency signals.

The above objects of the present invention are achieved by an intermediate frequency generating circuit having two frequency mixing circuits, the intermediate frequency generating circuit including: two local oscillating circuits applying local oscillation outputs to the two frequency mixing circuits, wherein the two local oscillating circuits are used as two voltage controlled oscillators for two PLL circuits, respectively; and the two PLL circuits excluding the two voltage controlled oscillators are provided within a single integrated circuit.

According to the present invention, the two PLL circuits excluding the two VCOs are provided within a single integrated circuit so that the construction for the PLL circuits can be simplified and the PLL circuits can be easily designed.

Alternately, the above objects of the present invention are achieved by an intermediate frequency generating circuit having a first intermediate frequency generating circuit and a second intermediate frequency generating circuit a first frequency mixer and a first local oscillator are provided in the first intermediate frequency generating circuit, a second frequency mixer and a second local oscillator are provided in the second intermediate frequency generating circuit and intermediate frequencies are output from the second intermediate frequency generating circuit, the intermediate frequency generating circuit including: a first PLL circuit and a second PLL circuit, wherein the first local oscillator is used as a voltage controlled oscillator for the first PLL circuit and the second local oscillator is used as a voltage controlled oscillator for the second PLL circuit; and the first PLL circuit and the second PLL circuit excluding the two voltage controlled oscillators are provided within a single integrated circuit.

According to the present invention, the first local oscillator is used as a voltage controlled oscillator for the first PLL circuit and the second local oscillator is used as a voltage controlled oscillator for the second PLL circuit. In addition, the PLL circuits excluding the voltage controlled oscillator for the first PLL circuit and the voltage controlled oscillator for the first PLL circuit are provided within a single integrated circuit. Therefore, the construction of the PLL circuits can be simplified and the PLL circuits can be easily designed.

Moreover, in the intermediate frequency generating circuit according to the present invention, the integrated circuit may be provided in the first intermediate frequency generating circuit.

According to the present invention, by providing the integrated circuit in the first intermediate frequency generating circuit, a reference frequency and digital setting signals indicating frequency division ratios to frequency dividers are applied only to the first intermediate frequency generating circuit. Therefore, it is possible to prevent the reference frequency and the setting signals from leaking to the second intermediate frequency generating circuit and mixing into an intermediate frequency signal.

Further, the first local oscillating circuit for the first PLL circuit is additionally integrated together in said integrated circuit.

According to the present invention, the two PLL circuits excluding the second local oscillating circuit for the second PLL circuit are integrated together in a single integrated circuit. Therefore, it is possible to reduce the number of circuits and to easily design the circuits.

Furthermore, at least one of the first intermediate frequency generating circuit, the second intermediate frequency generating circuit, the first local oscillating circuit for the first PLL circuit, the second local oscillating circuit for the second PLL circuit and the integrated circuit is formed as a block.

According to the present invention, by forming the circuit as a block, it is possible to eliminate mutual interference between blocks.

Other objects, features and advantages of the present invention will become more apparent from the following detailed description when read in conjunction with the accompanying drawings.

### BRIEF DESCRIPTION OF THE DRAWINGS

FIG.1 is a diagram showing an example of an intermediate frequency circuit in a telephone receiver module utilizing unused channels of a CATV line;
FIG.2 is a diagram showing a conventional PLL circuit;
FIG.3 is a diagram explaining an embodiment of an intermediate frequency generating circuit according to the present invention;
FIG.4 is a diagram showing a first oscillator circuit block 25, a PLL circuit block 26 and a second oscillator circuit block 29;
FIG.5 is a detailed diagram explaining the PLL circuits shown in FIG.4; and
FIG.6 is a diagram showing a modification of the embodiment according to the present invention.

### DESCRIPTION OF THE PREFERRED EMBODIMENTS

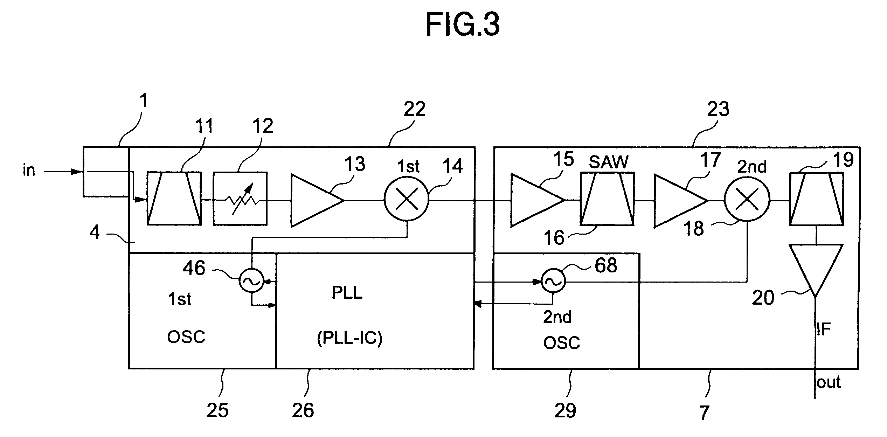

FIG.3 is a diagram explaining an embodiment of an intermediate frequency generating circuit according to the present invention. In FIG.3, parts that are the same as those shown in FIG.1 are given the same reference numbers and the explanation thereof will be omitted.

The intermediate frequency circuit in FIG.3 includes a first intermediate frequency generating circuit 22 and a second intermediate frequency generating circuit 23. The first intermediate frequency generating circuit 22 includes blocks, which are sectioned by partitions such as metal partitions, namely, a first frequency mixing circuit block 4, a first oscillator circuit block 25 and a PLL circuit block 26. The second intermediate frequency generating circuit 23 also includes blocks, namely, a second frequency mixing circuit block 7 and a second oscillator circuit block 29.

In FIG.3, the second PLL circuit block 8 in the second intermediate frequency generating circuit 3 in FIG.1 is provided in the same block as the first PLL circuit block 6 in the first intermediate frequency generating circuit 2 in FIG.1. Operations performed by all circuits in FIG.3 are in the same manner as those performed by all circuits in FIG.1.

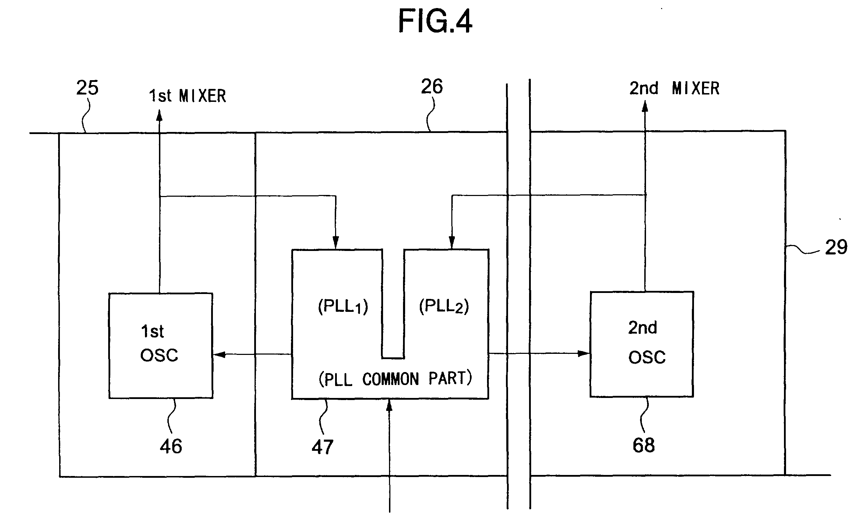

FIG.4 is a diagram showing a first oscillator circuit block 25, a PLL circuit block 26 and a second oscillator circuit block 29. A first oscillator 46 is provided in the first oscillator circuit block 25 and the second oscillator 68 is provided in the second oscillator circuit block 29. A PLL circuit 47 is provided in the PLL circuit block 26. The PLL circuit 47 includes a PLL1 for controlling the first oscillator 46, a PLL2 for controlling the second oscillator 68 and a PLL common part. That is, the PLL1 and the first oscillator 46 include one PLL circuit and the PLL2 and the second oscillator 68 include another PLL circuit.

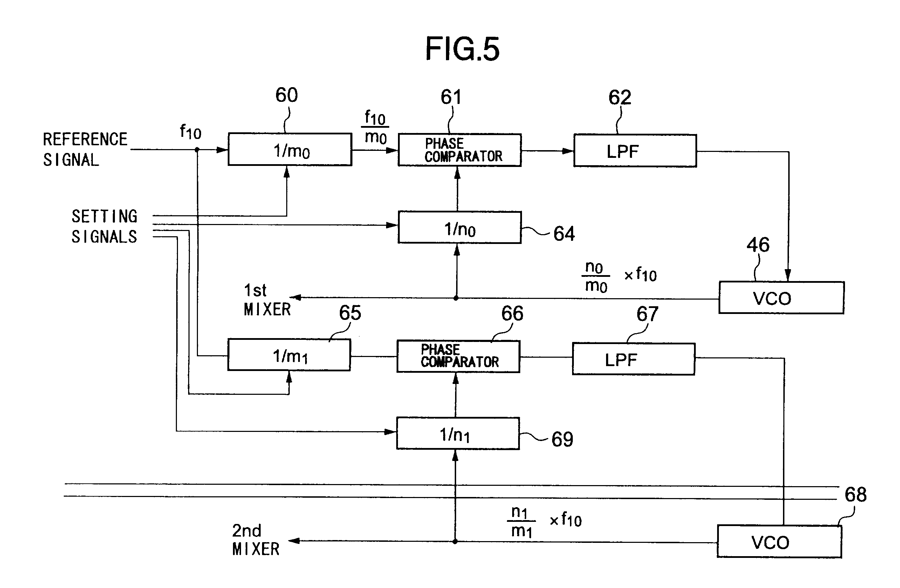

FIG.5 is a detailed diagram explaining the PLL circuits shown in FIG.4. A first PLL circuit includes a 1/m0-frequency divider 60 for dividing a frequency f10 of a reference signal by m0, a phase comparator 61, a LPF 62, a VOC 46 and 1/nO-frequency divider 64 for dividing a frequency from the VOC 46 by n0. A (n0/m0)*f10-frequency is obtained from an output of the VCO 46 (the first oscillator) and is applied to the first frequency mixer 14.

Also, the second PLL circuit includes a 1/m1-frequency divider 65 for dividing a frequency f10 of a reference signal by ml, a phase comparator 66, a LPF 67, a VOC 68 and 1/nl-frequency divider 69 for dividing a frequency from the VOC 68 by nl. A (n1/m1)*f10-frequency is obtained from an output of the VCO 68 (the second oscillator) and is applied to the second frequency mixer 18.

By providing one integrated circuit in the first intermediate frequency generating circuit in the above-mentioned manner, the reference frequency signal f10 and the digital setting signals showing frequency division ratios to the frequency dividers are applied to the first intermediate frequency generating circuit.

In addition, beats caused by spurious signal, which leaks to the second frequency mixer circuit block 7 in the conventional intermediate frequency generating circuit, can be eliminated.

Although the reference frequency signal f10 and the digital setting signals indicating frequency division ratios to the frequency dividers leak to the first intermediate frequency generating circuit, the reference frequency signal f10 and the setting signals are eliminated by the SAW and the BPF 19 in the second intermediate frequency generating circuit. Thus, the problems in the conventional intermediate frequency generating circuit do not occur.

Moreover, the reference signal and setting signals are used in common for the two PLL circuits. Therefore, the construction of circuits is simplified and the circuit may be easily designed. In addition, it is possible to provide the first and second intermediate frequency generating circuits on a single circuit board, instead of providing the first and second intermediate frequency generating circuits on independent circuit boards.

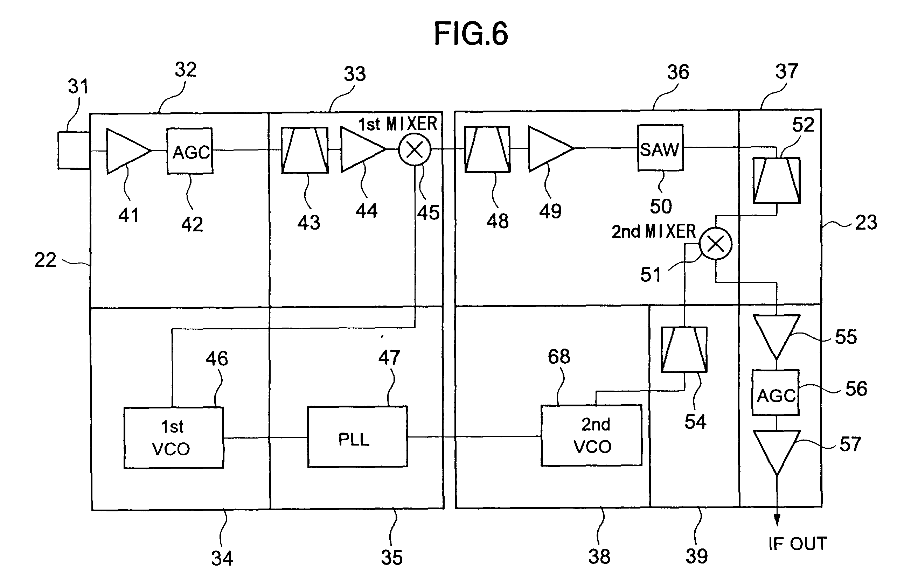

FIG.6 is a diagram showing a modification of the embodiment according to the present invention. The intermediate frequency generating circuit includes blocks, namely, a first intermediate frequency generating circuit 22 and a second intermediate frequency generating circuit 23. The first intermediate frequency generating circuit 22 includes an amplifier 41, an AGC 42, a BPF 43, an amplifier 44, a first frequency mixer 45, a first VCO 46 and a PLL 47.

Also, the second intermediate frequency generating circuit 23 includes a BPF 48, an amplifier 49, a SAW 50, a BPF 52, a second frequency mixer 51, a BOF 54, a second VCO 68, an amplifier 55, an AGC 56 and an amplifier 57.

Although the amplifiers 41 and 55 and the BPFs 48 and 52 are additionally provided, the basic operation is the same as that of the circuit shown in FIG.3.

In the embodiment described above, analog circuits are used are explained. But alternately, digital circuits may be used to form a part of or the entire intermediate frequency generating circuit.

Moreover, although the intermediate frequency generating circuit according to the present invention is applied to a receiver in the embodiment, the intermediate frequency generating circuit can be used for a transmitter. In this case, the PLL circuits are also provided in the first stage of the intermediate frequency generating circuit.

The present invention is not limited to the specifically disclosed embodiments, variations and modifications, and other variations and modifications may be made without departing from the scope of the present invention.

The present application is based on Japanese Priority Application No. 10-361623 filed December 18, 1998, the entire contents of which are hereby incorporated by reference.

## Claims

1. An intermediate frequency generating circuit having two frequency mixing circuits, characterized by:
two local oscillating circuits (46, 68) applying local oscillation outputs to said two frequency mixing circuits,
wherein said two local oscillating circuits are used as two voltage controlled oscillators for two PLL circuits, respectively, and
said two PLL circuits excluding said two voltage controlled oscillators are provided within a single integrated circuit (26).

2. An intermediate frequency generating circuit having a first intermediate frequency generating circuit and a second intermediate frequency generating circuit in which a first frequency mixer and a first local oscillator are provided in the first intermediate frequency generating circuit, a second frequency mixer and a second local oscillator are provided in the second intermediate frequency generating circuit, and intermediate frequencies are output from said second intermediate frequency generating circuit, said intermediate frequency generating circuit characterized by:
a first PLL circuit and a second PLL circuit,
wherein said first local oscillator (46) is used as a voltage controlled oscillator for the first PLL circuit and said second local oscillator (68) is used as a voltage controlled oscillator for the second PLL circuit; and
said first PLL circuit and said second PLL circuit excluding said two voltage controlled oscillators are provided within a single integrated circuit (26).

3. The intermediate frequency generating circuit as claimed in claim 2, characterized in that said integrated circuit (26) is provided in the first intermediate frequency generating circuit.

4. The intermediate frequency generating circuit as claimed in claim 3, characterized in that said voltage controlled oscillator (46) for said first PLL circuit is additionally integrated together in said integrated circuit (26).

5. The intermediate frequency generating circuit as claimed in claim 2, characterized in that at least one of said first intermediate frequency generating circuit (22), said second intermediate frequency generating circuit (23), said voltage controlled oscillator for said first PLL circuit, said voltage controlled oscillator (68) for said second PLL circuit and said integrated circuit (26) is formed as a block.
